# EUROPEAN PATENT APPLICATION

(11) **EP 3 054 477 A1**
(43) Date of publication of application: **10.08.2016**
(21) Application number: 14848960.2
(22) Date of filing: 08.09.2014
(51) Int. Cl.: H01L 21/337, H01L 21/338, H01L 27/098, H01L 29/778, H01L 29/808, H01L 29/812

(54) **SEMICONDUCTOR DEVICE AND METHOD FOR MANUFACTURING SAME**

(30) Priority: 30.09.2013 JP 2013204162
(71) Applicant: TOYOTA JIDOSHA KABUSHIKI KAISHA, Toyota-shi, Aichi-ken, 471-8571 (JP)
(72) Inventor: KANECHIKA Masakazu, Nagakute-shi Aichi 480-1192 (JP); KUWAHARA Makoto, Nagakute-shi Aichi 480-1192 (JP); UEDA Hiroyuki, Nagakute-shi Aichi 480-1192 (JP); TOMITA Hidemoto, Toyota-shi Aichi 471-8571 (JP)
(74) Representative: Kuhnen & Wacker
(86) International application number: PCT/JP2014/073677
(87) International publication number: WO 2015/045833

(57) **Abstract**

A semiconductor device includes a first compound semiconductor layer, a second compound semiconductor layer having a larger band gap than that of the first compound semiconductor layer, a p-type third compound semiconductor layer disposed above a portion of the second compound semiconductor layer, a p-type fourth compound semiconductor layer disposed above the third compound semiconductor layer and having a higher resistance than that of the third compound semiconductor layer, and a gate electrode disposed above the fourth compound semiconductor layer.

## Description

### Technical Field

The present application claims priority based on Japanese Patent Application No. 2013-204162 filed on September 30, 2013, the entire contents of which are hereby incorporated by reference into the present specification.

The present teachings disclose an art that relates to a semiconductor device having a heterojunction, and a manufacturing method of the same.

### Background Art

There has been known a semiconductor device that uses, as a channel, a two-dimensional electron gas layer formed at a heterojunction. As for the semiconductor device of this type, ones of a normally-off type have been developed, an example of which is disclosed in Japanese Patent Application Publication No. 2011-29507. In the description below, Japanese Patent Application Publication No. 2011-29507 will be referred to as Patent Literature 1. In the semiconductor device in Patent Literature 1, a p-type semiconductor layer is disposed at a portion of a front surface of a semiconductor layer having a heterojunction surface. Furthermore, an n-type semiconductor layer is disposed at a front surface of the p-type semiconductor layer, and a gate electrode is disposed at a front surface of the n-type semiconductor layer. In the semiconductor device in Patent Literature 1, when no on-voltage is applied to the gate electrode, a depletion layer that extends from the p-type semiconductor layer causes a portion of the two-dimensional electron gas layer to disappear, to thereby realize normally-off. Moreover, in the semiconductor device in Patent Literature 1, the n-type semiconductor layer is disposed at the front surface of the p-type semiconductor layer to thereby prevent a gate current from flowing when an on-voltage is applied to the gate electrode.

### Summary of Invention

In the semiconductor device in Patent Literature 1, a positive voltage is applied to the gate electrode to thereby reduce the depletion layer that has extended from the p-type semiconductor layer to the heterojunction surface, and turn on the semiconductor device. When the positive voltage is applied to the gate electrode, however, a pn junction between the n-type semiconductor layer and the p-type semiconductor layer is reverse-biased, and a depletion layer is formed at an interface of the pn junction. A portion of the positive voltage applied to the gate electrode is applied to the pn junction between the n-type semiconductor layer and the p-type semiconductor layer, and hence a longer time is required until, after the application of the positive voltage to the gate electrode, the depletion layer that has extended at the heterojunction surface is reduced and a two-dimensional electron gas layer is formed. In other words, a switching speed of the semiconductor device becomes lower. The present teachings disclose a semiconductor device with its switching speed improved, and a manufacturing method of the semiconductor device.

The art disclosed in the present teachings is characterized in that a high-resistance p-type semiconductor layer is disposed between the p-type semiconductor layer and the gate electrode. The high-resistance p-type semiconductor layer can suppress a flow of a gate current when a positive voltage is applied to the gate electrode. Furthermore, in the semiconductor device disclosed in the present teachings, no pn junction surface exists below the gate electrode, and hence superior responsiveness is obtained when the positive voltage is applied to the gate electrode. Accordingly, the semiconductor device disclosed in the present teachings is suitable for a high-speed switching operation.

A semiconductor device taught in the present teachings comprises: a first compound semiconductor layer; a second compound semiconductor layer disposed on the first compound semiconductor layer and having a larger band gap than that of the first compound semiconductor layer; a p-type third compound semiconductor layer disposed above a portion of the second compound semiconductor layer; a p-type fourth compound semiconductor layer disposed above the third compound semiconductor layer and having a higher resistance than that of the third compound semiconductor layer; and a gate electrode disposed above the fourth compound semiconductor layer.

The present teachings also provide a manufacturing method of the above-described semiconductor device. The manufacturing method comprises: a first step of forming a second compound semiconductor layer on a first compound semiconductor layer, the second compound semiconductor layer having a larger band gap than that of the first compound semiconductor layer; a second step of forming a p-type third compound semiconductor layer above a portion of the second compound semiconductor layer; a third step of forming a p-type fourth compound semiconductor layer above the third compound semiconductor layer, the fourth compound semiconductor layer having a higher resistance than that of the third compound semiconductor layer; and a fourth step of forming a gate electrode above the fourth compound semiconductor layer.

### Brief Description of Drawings

FIG. 1 shows a cross-sectional view of a semiconductor device in a first embodiment;
FIG. 2 shows a manufacturing step of a first manufacturing method of the semiconductor device;
FIG. 3 shows a manufacturing step of the first manufacturing method of the semiconductor device;
FIG. 4 shows a manufacturing step of the first manufacturing method of the semiconductor device;
FIG. 5 shows a manufacturing step of a second manufacturing method of the semiconductor device;
FIG. 6 shows a manufacturing step of the second manufacturing method of the semiconductor device;
FIG. 7 shows a manufacturing step of the second manufacturing method of the semiconductor device; and
FIG. 8 shows a cross-sectional view of the semiconductor device in a second embodiment.

### Description of Embodiments

Some of the technical features of the embodiments disclosed in the present teachings will hereinafter be described. Notably, each matter described below has technical usefulness on its own.

A semiconductor device disclosed in the present teachings may include a first compound semiconductor layer, a second compound semiconductor layer, a p-type third compound semiconductor layer, a p-type fourth compound semiconductor layer, and a gate electrode. The second compound semiconductor layer may be disposed on the first compound semiconductor layer, and may have a larger band gap than that of the first compound semiconductor layer. The third compound semiconductor layer may be disposed above a portion of the second compound semiconductor layer. The fourth compound semiconductor layer may be disposed above the third compound semiconductor layer, and may have a higher resistance than that of the third compound semiconductor layer. The gate electrode may be disposed above the fourth compound semiconductor layer. The semiconductor device disclosed in the present teachings may be of a horizontal type or a vertical type. Between every two compound semiconductor layers, another compound semiconductor layer may be disposed as needed. Here, the compound semiconductor is preferably a wide band gap semiconductor. Specifically, the compound semiconductor includes a nitride semiconductor, and silicon carbide.

A concentration of p-type impurities contained in the fourth compound semiconductor layer may be lower than a concentration of p-type impurities contained in the third compound semiconductor layer. The fourth compound semiconductor layer can be ensured to have a higher resistance than that of the third compound semiconductor layer.

The fourth compound semiconductor layer may have a lower crystallinity than that of the third compound semiconductor layer. In this case as well, the fourth compound semiconductor layer can be ensured to have a higher resistance than that of the third compound semiconductor layer. Notably, the fourth compound semiconductor layer may have the concentration of p-type impurities lower than that of the third compound semiconductor layer, and additionally have the lower crystallinity than that of the third compound semiconductor layer.

The first, second, third, and fourth compound semiconductor layers may comprise nitride semiconductor. The nitride semiconductor may be the one represented by a general formula AlₓGa_{y}In_{1-X-Y}N (0 ≤ X ≤ 1, 0 ≤ Y ≤ 1, 0 ≤ 1 - X - Y ≤ 1). Gallium nitride (GaN) is given as an example of the first compound semiconductor layer. Aluminum gallium nitride (AlGaN) is given as an example of the second, third, and fourth compound semiconductor layers. Embodiments

### (First Embodiment)

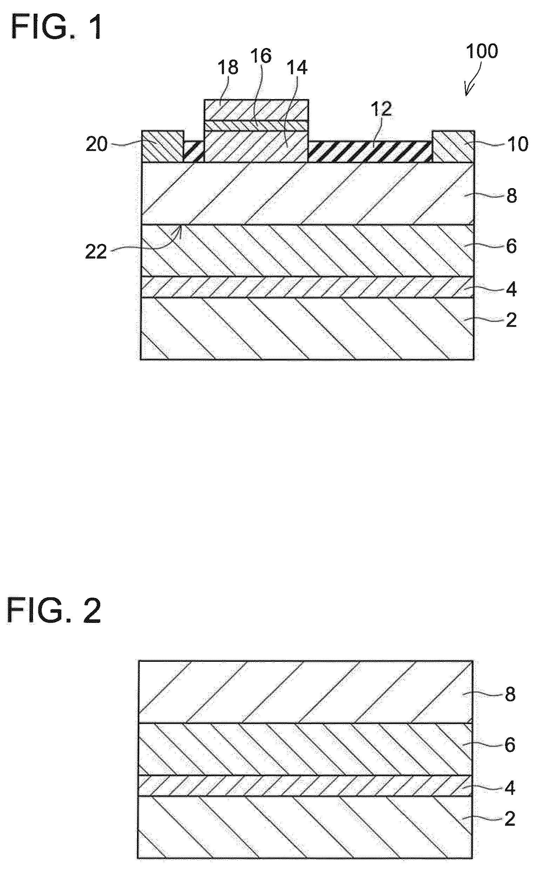

As shown in FIG. 1, a semiconductor device 100 is of a horizontal type, and comprises a sapphire substrate 2, a buffer layer 4, a first compound semiconductor layer 6, a second compound semiconductor layer 8, a third compound semiconductor layer 14, a fourth compound semiconductor layer 16, a gate electrode 18, a source electrode 20, and a drain electrode 10.

The buffer layer 4, a material of which is aluminum nitride (AlN), is disposed at a front surface of the sapphire substrate 2. The first compound semiconductor layer 6 is disposed at a front surface of the buffer layer 4. A material of the first compound semiconductor layer 6 is gallium nitride. The first compound semiconductor layer 6 is a non-doped one. The second compound semiconductor layer 8 is disposed at a front surface of the first compound semiconductor layer 6, and its material is aluminum gallium nitride. The second compound semiconductor layer 8 is a non-doped one. In other words, the first and second compound semiconductor layers 6 and 8 are i-type nitride semiconductors. A band gap of the second compound semiconductor layer 8 is larger than that of the first compound semiconductor layer 6. The first and second compound semiconductor layers 6 and 8 form a heterojunction, and a two-dimensional electron gas layer is formed in vicinity of a junction surface 22 between the first and second compound semiconductor layers 6 and 8. Notably, the first compound semiconductor layer 6 has a thickness of approximately 2 µm to 3 µm, and the second compound semiconductor layer 8 has a thickness of approximately 15 nm to 25 nm.

The third compound semiconductor layer 14 is disposed at a portion of a front surface of the second compound semiconductor layer 8. A material of the third compound semiconductor layer 14 is aluminum gallium nitride. The third compound semiconductor layer 14 contains approximately 1 × 10¹⁹ cm³ magnesium (Mg), which serves as p-type impurities. The fourth compound semiconductor layer 16 is disposed at a front surface of the third compound semiconductor layer 14. A material of the fourth compound semiconductor layer 16 is aluminum gallium nitride. The content of aluminum (Al) contained in the third compound semiconductor layer 14 is the same as that of the second compound semiconductor layer 8. The fourth compound semiconductor layer 16 contains approximately 1 × 10¹⁷ to 5 × 10¹⁸ cm³ magnesium. The concentration of p-type impurities (Mg) contained in the fourth compound semiconductor layer 16 is lower than the concentration of p-type impurities contained in the third compound semiconductor layer 14. Accordingly, the fourth compound semiconductor layer 16 has a higher resistance than that of the third compound semiconductor layer 14. Notably, the third compound semiconductor layer 14 has a thickness of approximately 70 nm to 100 nm, and the fourth compound semiconductor layer 16 has a thickness of approximately 10 nm to 20 nm.

The gate electrode 18 is disposed at a front surface of the fourth compound semiconductor layer 16, and is placed between the source electrode 20 and the drain electrode 10. A material of the gate electrode 18 is nickel (Ni). The gate electrode 18 is ohmic-connected to the fourth compound semiconductor layer 16. The source electrode 20 and the drain electrode 10 are disposed to be apart from each other, at portions of the front surface of the second compound semiconductor layer 8. Each of the source electrode 20 and the drain electrode 10 is a layered electrode configured of titanium (Ti) and aluminum, and is ohmic-connected to the second compound semiconductor layer 8. The source electrode 20 and the drain electrode 10 are insulated from the gate electrode 18 by a passivation film 12.

The semiconductor device 100 is a normally-off-type HEMT (High Electron Mobility Transistor). When a positive voltage is applied to the drain electrode 10, a ground voltage is applied to the source electrode 20, and a positive voltage is applied to the gate electrode 18, electrons travel from the source electrode 20 toward the drain electrode 10 via the two-dimensional electron gas layer formed in the vicinity of the junction surface 22 between the first and second compound semiconductor layers 6 and 8. The semiconductor device 100 is thereby brought into an on-state.

When the application of a positive voltage to the gate electrode 18 is stopped, a depletion layer extends from the third compound semiconductor layer 14 toward the junction surface 22, and electrons in the two-dimensional electron gas layer are depleted, as a result of which the travel of electrons via the two-dimensional electron gas layer is stopped. The semiconductor device 100 is thereby brought into an off-state. When a positive voltage is applied again to the gate electrode 18, the depletion layer that has extended to the junction surface 22 disappears, and the semiconductor device 100 is switched from the off-state to the on-state.

As described above, the concentration of p-type impurities contained in the fourth compound semiconductor layer 16 is lower than the concentration of p-type impurities contained in the third compound semiconductor layer 14. In other words, the fourth compound semiconductor layer 16 has a higher resistance than that of the third compound semiconductor layer 14. Accordingly, a flow of a gate current in the on-state can further be suppressed than in a configuration in which the gate electrode 18 is directly disposed at the front surface of the third compound semiconductor layer 14. Moreover, the fourth compound semiconductor layer 16 contains p-type impurities, just like the third compound semiconductor layer 14. Accordingly, even if a positive voltage is applied to the gate electrode 18, no depletion layer extends from the interface between the third and fourth compound semiconductor layers 14 and 16.

As described above, in the conventional semiconductor device, an n-type compound semiconductor layer is disposed at a front surface of a p-type compound semiconductor layer, which corresponds to the third compound semiconductor layer 14, and a gate electrode is disposed at a front surface of that n-type compound semiconductor layer. Accordingly, when a positive voltage is applied to the gate electrode, a depletion layer extends from an interface between the p-type compound semiconductor layer and the n-type compound semiconductor layer. In the conventional semiconductor device, a portion of the positive voltage applied to the gate electrode is applied to the pn junction between the p-type compound semiconductor layer and the n-type compound semiconductor layer, and hence a longer time is required until the depletion layer that has extended from the p-type compound semiconductor layer to the heterojunction surface is reduced and the two-dimensional electron gas layer is formed.

In the semiconductor device 100, when it is switched from the off-state to the on-state, no depletion layer extends from the interface between the third and fourth compound semiconductor layers 14 and 16. Accordingly, in the semiconductor device 100, when a positive voltage is applied to the gate electrode 18, the depletion layer that has extended to the heterojunction surface quickly disappears. In other words, the semiconductor device 100 has a higher switching speed than that of the conventional semiconductor device.

Notably, from a viewpoint of suppressing a flow of the gate current, it can also be conceived that an insulation film (a gate insulation film) is disposed in place of the fourth compound semiconductor layer 16, and the gate electrode is disposed at a front surface of that insulation film. In such a configuration, there is no need to interpose an n-type compound semiconductor layer between the gate electrode and the p-type compound semiconductor layer. In the case of this semiconductor device, however, when a positive voltage is applied to the gate electrode, electrons may accumulate at an interface between the gate insulation film and the p-type compound semiconductor layer, causing fluctuations in threshold voltage. In the semiconductor device 100, no electrons accumulate at the interface between the third and fourth compound semiconductor layers 14 and 16, and hence a threshold voltage is stable.

### (First Manufacturing Method)

A first manufacturing method of the semiconductor device 100 will be described. As shown in FIG. 2, the buffer layer 4, a material of which is AlN, is grown at the front surface of the sapphire substrate 2. Afterwards, the first compound semiconductor layer 6, a material of which is GaN, is crystal-grown (a first step), and the second compound semiconductor layer 8, a material of which is AlGaN, is crystal-grown (a second step). The second compound semiconductor layer 8 can be crystal-grown successively after the crystal growth of the first compound semiconductor layer 6, by allowing the first compound semiconductor layer 6 to have a prescribed thickness, and then changing its raw material gas (starting to supply an Al-containing gas). Notably, the buffer layer 4 is disposed to thereby stabilize a crystal structure of the first compound semiconductor layer 6.

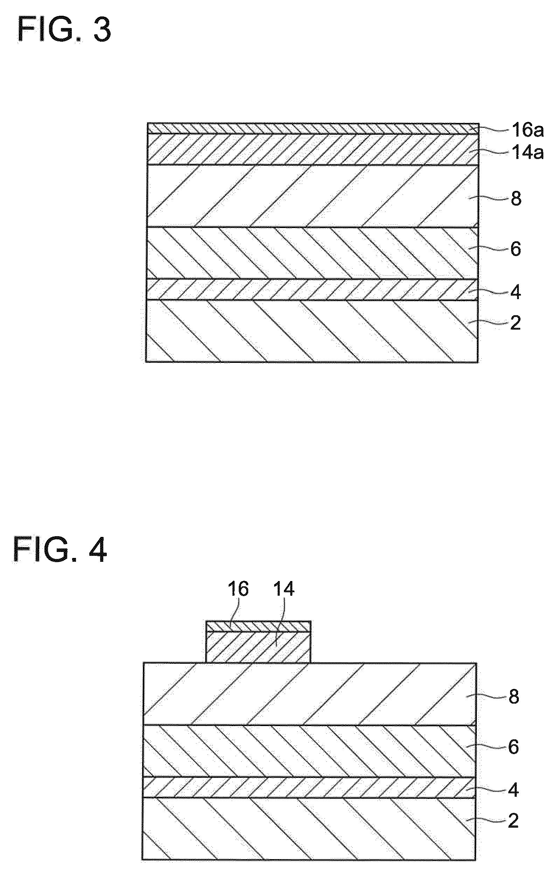

Next, as shown in FIG. 3, a high-concentration p-type AlGaN layer 14a that contains a high concentration of p-type impurities is crystal-grown at the front surface of the second compound semiconductor layer 8 (a third step). Afterwards, a low-concentration p-type AlGaN layer 16a that has a lower concentration of p-type impurities than the high-concentration p-type AlGaN layer 14a does is crystal-grown at a front surface of the high-concentration p-type AlGaN layer 14a (a fourth step). The high-concentration p-type AlGaN layer 14a can be crystal-grown successively after the crystal growth of the second compound semiconductor layer 8 by allowing the second compound semiconductor layer 8 to have a prescribed thickness, and then changing the raw material gas (starting to supply a Mg-containing gas). Moreover, the low-concentration p-type AlGaN layer 16a can be crystal-grown successively after the crystal growth of the high-concentration p-type AlGaN layer 14a by allowing the high-concentration p-type AlGaN layer 14a to have a prescribed thickness, and then changing the raw material gas (decreasing the Mg concentration in the raw material gas).

Next, as shown in FIG. 4, an etching mask (not shown) is formed at a portion of the low-concentration p-type AlGaN layer 16a, and a portion of each of the low-concentration p-type AlGaN layer 16a and the high-concentration p-type AlGaN layer 14a where no etching mask is formed is etched until the second compound semiconductor layer 8 is exposed. The third and fourth compound semiconductor layers 14 and 16 are thereby completed. Afterwards, the etching mask is removed, and the source electrode 20, the gate electrode 18, the drain electrode 10, and the passivation film 12 are formed by a known method to thereby complete the semiconductor device 100 shown in FIG. 1.

Notably, the fourth compound semiconductor layer 16 may have a lower crystallinity than that of the third compound semiconductor layer 14. By allowing the fourth compound semiconductor layer 16 to have a lower crystallinity than that of the third compound semiconductor layer 14, the fourth compound semiconductor layer 16 can be ensured to have a higher resistance than that of the third compound semiconductor layer 14. Notably, in this case, the concentration of p-type impurities (Mg) contained in the fourth compound semiconductor layer 16 may be the same as that of the third compound semiconductor layer 14, or may be lower than that of the third compound semiconductor layer 14. In other words, the fourth compound semiconductor layer 16 may only need to contain p-type impurities and have a higher resistance than that of the third compound semiconductor layer 14. Hereinafter will be described a manufacturing method of the semiconductor device 100 in which the fourth compound semiconductor layer 16 has a lower crystallinity than that of the third compound semiconductor layer 14.

### (Second Manufacturing Method)

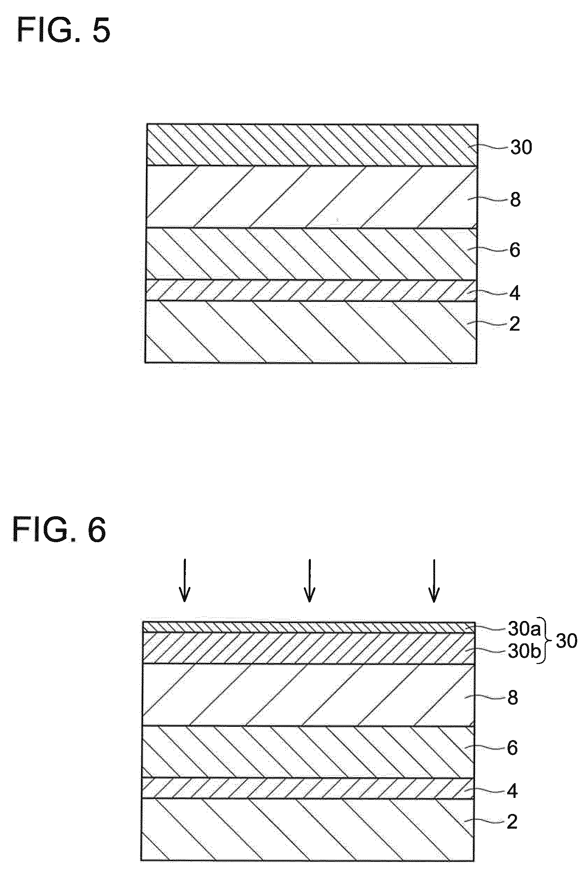

With reference to FIGS. 5 to 7, a second manufacturing method of the semiconductor device 100 will be described. Initially, as in the first manufacturing method, the buffer layer 4, the first compound semiconductor layer 6, and the second compound semiconductor layer 8 are formed above the sapphire substrate 2 (see FIG. 2). Next, as shown in FIG. 5, a p-type AlGaN layer 30 that contains p-type impurities is crystal-grown at the front surface of the second compound semiconductor layer 8. The thickness of the p-type AlGaN layer 30 that contains p-type impurities corresponds to a sum of the thickness of the third compound semiconductor layer 14 and the thickness of the fourth compound semiconductor layer 16 (see FIG. 1). Moreover, the concentration of the p-type impurities is adjusted just like the concentration of impurities in the third compound semiconductor layer 14. The p-type AlGaN layer 30 can be crystal-grown successively after the crystal growth of the second compound semiconductor layer 8.

Next, as shown in FIG. 6, a front surface of the p-type AlGaN layer 30 is exposed to plasma, to lower the crystallinity of a front surface layer of the p-type AlGaN layer 30. For example, the front surface of the p-type AlGaN layer 30 can be exposed to ions of chlorine (Cl), fluorine (F), and argon (Ar) with acceleration energy equal to or lower than 100 V, to thereby remove nitrogen (N) from the front surface layer of the p-type AlGaN layer 30, and allow the front surface layer to have a high resistance. Under this condition, the thickness of the high-resistance layer (a front surface layer part 30a of the p-type AlGaN layer 30) can be controlled to approximately 10 nm. The crystallinity of the front surface layer part 30a becomes lower than that of a deeper part 30b, of the p-type AlGaN layer 30. Specifically, nitrogen atoms are more decreased in the front surface layer part 30a than in the deeper part 30b, of the p-type AlGaN layer 30. Consequently, the front surface layer part 30a has a higher resistance than that of the deeper part 30b.

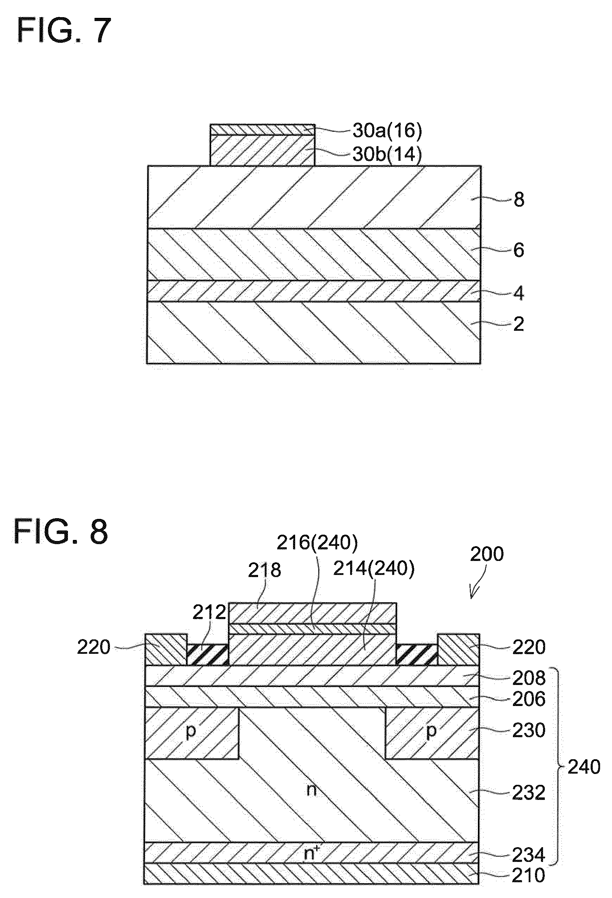

Next, as shown in FIG. 7, an etching mask (not shown) is formed at a portion of the p-type AlGaN layer 39, and a portion of the p-type AlGaN layer 30 where no etching mask is formed is etched until the second compound semiconductor layer 8 is exposed. The third and fourth compound semiconductor layers 14 and 16 are thereby completed. The subsequent steps are the same as those in the first manufacturing method, and hence will not be described.

### (Second Embodiment)

With reference to FIG. 8, a semiconductor device 200 will be described. The semiconductor device 200 is of a vertical type, and includes a drain electrode 210, a semiconductor layer 240 disposed above the drain electrode 210, and a source electrode 220 and a gate electrode 218 both disposed at a front surface of the semiconductor layer 240. The semiconductor layer 240 includes a substrate 234 that contains a high concentration of n-type impurities, a drift layer 232 that contains a lower concentration of n-type impurities than the substrate 234 does, anembedded p-type compound semiconductor layer 230 that contains a high concentration of p-type impurities, a first compound semiconductor layer 206 and a second compound semiconductor layer 208, both of which contain substantially no impurities, a third compound semiconductor layer 214 that contains a high concentration of p-type impurities, and a fourth compound semiconductor layer 216 that contains a lower concentration of p-type impurities than the third compound semiconductor layer 214 does.

The drain electrode 210 is ohmic-connected to a back surface of the substrate 234. The drain electrode 210 is a layered electrode configured of titanium and aluminum. A material of the substrate 234 is gallium nitride (GaN). The substrate 234 contains approximately 1 × 10¹⁸ to 3 × 10¹⁸ cm⁻³ silicon (Si), as n-type impurities. The substrate 234 has a thickness of approximately 100 µm to 350 µm. The drift layer 232 is disposed at a front surface of the substrate 234. A material of the drift layer 232 is gallium nitride. The drift layer 232 contains approximately 1 × 10¹⁶ to 2 × 10¹⁶ cm⁻³ silicon (Si), as n-type impurities. The drift layer 232 has a thickness of approximately 8 µm to 12 µm.

The p-type compound semiconductor layer 230 is disposed distributedly in a front surface layer of the drift layer 232. The p-type compound semiconductor layer 230 contains approximately 1 × 10¹⁹ to 5 × 10¹⁹ cm⁻³ magnesium (Mg), as p-type impurities. The p-type compound semiconductor layer 230 has a thickness (a length in a direction that links the source electrode 220 and the drain electrode 210) of approximately 0.5 µm to 1.0 µm. The drift layer 232 is interposed between the adjacent p-type compound semiconductor layer 230.

The first compound semiconductor layer 206 is disposed at front surfaces of the drift layer 232 and the p-type compound semiconductor layer 230. A material of the first compound semiconductor layer 206 is gallium nitride. The first compound semiconductor layer 206 has a thickness of approximately 0.1 µm to 0.2 µm. The second compound semiconductor layer 208 is disposed at a front surface of the first compound semiconductor layer 206. A material of the second compound semiconductor layer 208 is aluminum gallium nitride. The second compound semiconductor layer 208 has a thickness of approximately 15 nm to 25 nm. The first compound semiconductor layer 206 and the second compound semiconductor layer 208 form a heterojunction.

The third compound semiconductor layer 214 is disposed at a portion of a front surface of the second compound semiconductor layer 208. In planar view, the third compound semiconductor layer 214 overlaps a portion of the drift layer 232 where no p-type compound semiconductor layer 230 is formed. A material of the third compound semiconductor layer 214 is aluminum gallium nitride. The third compound semiconductor layer 214 contains approximately 1 × 10¹⁹ cm⁻³ magnesium, as p-type impurities. The third compound semiconductor layer 214 has a thickness of approximately 70 nm to 100 nm. The fourth compound semiconductor layer 216 is disposed at a front surface of the third compound semiconductor layer 214. A material of the fourth compound semiconductor layer 216 is aluminum gallium nitride. The fourth compound semiconductor layer 16 contains approximately 1 × 10¹⁷ to 5 × 10¹⁸ cm⁻³ magnesium. The fourth compound semiconductor layer 216 has a thickness of approximately 10 nm to 20 nm.

The gate electrode 218 is disposed at a front surface of the fourth compound semiconductor layer 216. A material of the gate electrode 18 is nickel. The gate electrode 218 is ohmic-connected to the fourth compound semiconductor layer 216. The source electrode 220 is disposed at a portion of the front surface of the second compound semiconductor layer 208. The source electrode 220 is a layered electrode configured of titanium and aluminum, and is ohmic-connected to the second compound semiconductor layer 208. The source electrode 220 is insulated from the gate electrode 218 by a passivation film 212. When the semiconductor device 200 is viewed in planar view, a gap between the source electrode 220 and the gate electrode 218 overlaps the p-type compound semiconductor layer 230.

In the semiconductor device 200, when a positive voltage is applied to the drain electrode 210, a ground voltage is applied to the source electrode 220, and a positive voltage is applied to the gate electrode 218, electrons supplied from the source electrode 220 travel in a two-dimensional electron gas layer in a lateral direction, in vicinity of a junction surface between the first and second compound semiconductor layers 206 and 208. The electrons travel through the drift layer 232 from between the p-type compound semiconductor layer 230, pass through the substrate 234, and reach the drain electrode 10.

In the case of the semiconductor device 200, when the application of the positive voltage to the gate electrode 218 is stopped, a depletion layer extends from the third compound semiconductor layer 214 toward the heterointerface, and another depletion layer also extends from the p-type compound semiconductor layer 230 toward the heterointerface. When the semiconductor device 200 is turned off, a conduction path from the source electrode 220 to the drain electrode 210 can more reliably be interrupted.

Specific examples of the present invention are described above in detail, but these examples are merely illustrative and place no limitation on the scope of the patent claims. The technology described in the patent claims also encompasses various changes and modifications to the specific examples described above. The technical elements explained in the present specification or drawings provide technical utility either independently or through various combinations. The present invention is not limited to the combinations described at the time the claims are filed. Further, the purpose of the examples shown by the present specification or drawings is to satisfy multiple objectives simultaneously, and satisfying any one of those objectives gives technical utility to the present invention.

## Claims

1. A semiconductor device comprising:
a first compound semiconductor layer;
a second compound semiconductor layer disposed on the first compound semiconductor layer and having a larger band gap than that of the first compound semiconductor layer;
a p-type third compound semiconductor layer disposed above a portion of the second compound semiconductor layer;
a p-type fourth compound semiconductor layer disposed above the third compound semiconductor layer and has a higher resistance than that of the third compound semiconductor layer; and
a gate electrode disposed above the fourth compound semiconductor layer.

2. The semiconductor device according to claim 1, wherein a concentration of p-type impurities contained in the fourth compound semiconductor layer is lower than a concentration of p-type impurities contained in the third compound semiconductor layer.

3. The semiconductor device according to claim 1 or 2, wherein the fourth compound semiconductor layer has a lower crystallinity than that of the third compound semiconductor layer.

4. The semiconductor device according to any one of claims 1 to 3, wherein the first compound semiconductor layer, the second compound semiconductor layer, the third compound semiconductor layer and the fourth compound semiconductor layer comprise nitride semiconductor.

5. A manufacturing method of a semiconductor device, the method comprising:
a first step of forming a second compound semiconductor layer on a first compound semiconductor layer, the second compound semiconductor layer having a larger band gap than that of the first compound semiconductor layer;
a second step of forming a p-type third compound semiconductor layer above a portion of the second compound semiconductor layer;
a third step of forming a p-type fourth compound semiconductor layer above the third compound semiconductor layer, the fourth compound semiconductor layer having a higher resistance than that of the third compound semiconductor layer; and
a fourth step of forming a gate electrode above the fourth compound semiconductor layer.

6. The manufacturing method according to claim 5, wherein the third step comprises crystal-growing the fourth compound semiconductor layer above the third compound semiconductor layer, the fourth compound semiconductor layer having a concentration of p-type impurities lower than a concentration of p-type impurities in the third compound semiconductor layer.

7. The manufacturing method according to claim 5, wherein the second step and the third step comprise:
forming a p-type compound semiconductor layer above the portion of the second compound semiconductor layer; and
exposing a surface of the p-type compound semiconductor layer to plasma,
wherein a portion of the p-type compound semiconductor layer that was not exposed to the plasma serves as the third compound semiconductor layer, and a portion of the p-type compound semiconductor layer that was exposed to the plasma serves as the fourth compound semiconductor layer.
